# EUROPEAN PATENT SPECIFICATION

(11) **EP 0 487 739 B1**
(45) Date of publication and mention of the grant of the patent: **11.12.1996**
(21) Application number: 91910195.6
(22) Date of filing: 31.05.1991
(51) Int. Cl.: H01L 27/115

(54) **SEMICONDUCTOR DEVICE AND A METHOD OF MANUFACTURING SUCH A SEMICONDUCTOR DEVICE**
HALBLEITERANORDNUNG UND EIN VERFAHREN ZUR HERSTELLUNG EINER SOLCHEN HALBLEITERANORDNUNG
DISPOSITIFS A SEMICONDUCTEURS ET UN PROCEDE DE FABRICATION DE TELLES DISPOSITIFS A SEMICONDUCTEURS

(30) Priority: 01.06.1990 JP 143563/90
(43) Date of publication of application: 03.06.1992
(73) Proprietor: RAMTRON INTERNATIONAL CORPORATION, Colorado Springs, Colorado 80921 (US)
(72) Inventor: KATO, Koji, Suwa-shi, Nagano-ken 392 (JP)
(74) Representative: Quinterno, Giuseppe
(86) International application number: PCT/JP91/00735
(87) International publication number: WO 91/19321

(56) References cited:
- EP-A- 0 338 157
- JP-A- 1 251 760
- US-A- 4 149 302

## Description

The present invention relates to a method for forming a semiconductor device such as a memory, and in particular, an electrically rewritable non-volatile memory having a ferroelectric material. The invention also relates to a semiconductor device of the type defined in the preamble of Claim 4.

In a conventional semiconductor non-volatile memory, use is commonly made of an MIS-type transistor having a phenomenon that the surface potential of a silicon substrate is modulated by injecting a load from the silicon substrate into a trap in an insulating gate or a floating gate, and the MIS-type transistor is used similarly to an EPROM (ultraviolet ray erasable non-volatile memory), EEPROM (electrically rewritable non-volatile memory), and the like.

However, these non-volatile memories have disadvantages such as a high information rewriting voltage, typically between 12-20 volts and very long rewriting time (for example, several ten msec in the case of an EEPROM). Moreover, the number of rewriting information rewriting is a problem when the memory is used repetitively.

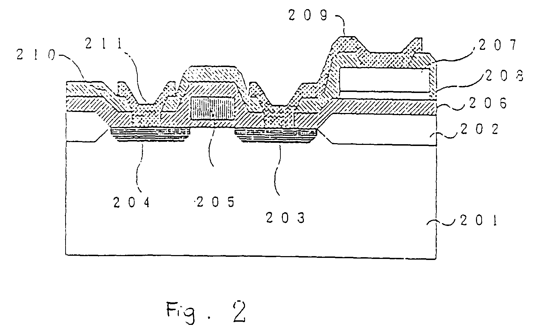

In a non-volatile memory having a ferroelectric material which can electrically inverse polarization, write-in time and read-out time are substantially the same in principle, and polarization is maintained even if an electric source is cut off, so that this non-volatile memory has as an ideal. With respect to a non-volatile memory having a ferroelectric material, U.S. Patent No. 4,149,302 proposes a structure integrating a capacitor consisting of a ferroelectric material on a silicon substrate, and U.S. Patent No. 3,832,700 proposes a non-volatile memory wherein a ferroelectric film is on the gate portion of a MIS-type transistor. Moreover, in IEDM '87, pp. 850-851, a non-volatile memory having a structure laminated in a MOS-type semiconductor device such as shown in Fig. 2 was disclosed. In Fig. 2, a P-type Si substrate 201, an element separating LOCOS oxide film 202, an N-type diffusion layer 203, such as a source region, and an N-type diffusion layer 204, such as a drain region, are shown. A gate electrode 205, and an interlayer insulating film 206 are also shown. A ferroelectric film 207 of a capacitor is formed when sandwiched between a lower electrode 208 and an upper electrode 209. A second interlayer insulating film 210, and a wiring electrode 211 comprises Al. Such structure of laminating on the upper portion of an MOS-type semiconductor device should distribute wires between the electrode of a ferroelectric film and the high concentration diffusion layer, such as source and drain regions on the semiconductor substrate with the use of Al or other conventional interconnect materials. One problem with the prior art, as shown in Fig. 2, is the large amount of area occupied by the transistor and ferroelectric capacitor regions.

A device according to the preamble of Claim 4 is known from European Patent Application EP-A-0 338 157 which discloses a DRAM device comprising a P-type silicon substrate with source and drain regions formed by N+ diffusions, and a gate electrode of doped polysilicon. An insulated layer above the substrate has openings over the source and drain regions. A capacitor is located above the source region and comprises a lower metallic electrode formed in the opening and in contact with the N+ diffusion, an upper metallic electrode and a dielectric formed by a ferroelectric film located between the two electrodes.

The object of the present invention is to provide an improved semiconductor device, particularly a low cost non-volatile memory having a small memory cell area and fast information rewriting times, as well as an improved method for the manufacture thereof.

This object is achieved according to the invention by a method having the features defined in Claim 1 and a semiconductor device as defined in claim 4.

In the drawings :

Figs. 1(a)-(c) are cross-sectional views showing the main steps of one of the preferred embodiments of the method for manufacturing a semiconductor device according to the present invention.

Fig. 2 is a cross-sectional view of a non-volatile memory according to the prior art.

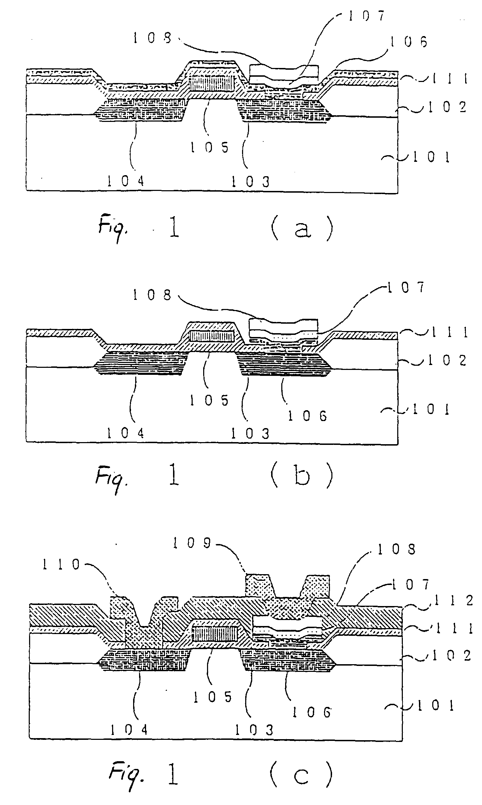

Figs. 1(a)-(c) are cross-sectional views showing the main steps of one embodiment of the method for manufacturing a semiconductor device according to the invention. The method for manufacturing the semiconductor device according to the invention is explained by reference to Fig. 1. For the sake of explanation, an embodiment having an Si substrate and an N-channel transistor is explained.

Fig. 1(a) shows a P-type Si substrate 101 and uses a wafer of specific resistance such as 20 ohm-cm. An element separating insulating film 102 and an oxide film with a thickness of 6000 Å is formed by a LOCOS method by a known technique. An N-type diffusion layer 103, such as a source region, is formed by ion injection of phosphorus at 80 KeV 5x10¹⁵ cm⁻². An N-type diffusion layer, such as a drain region, is formed simultaneously with layer 103. A gate electrode 105, an interlayer insulating film 111, comprised of 4000 Å of phosphorous glass deposited by chemical vapor deposition (CVD) and a contact hole are formed by conventional photolithography and etch techniques. A polysilicon film 106 is formed with a thickness of 5000 Å, by a chemical vapor phase growing method. In this case, the film thickness of the polysilicon film is preferably at least the same as that of said first interlayer insulating film. One of electrodes 107 of a ferroelectric film is formed by sputtering Pt, Pd or the like. Film 108 comprises of PbTiO₃, PZT (mixed crystal of PbTiO₃ and PbZrO₃), PLZT (La-doped PZT) and the like, and is formed by a sputtering method or the like.

Next, after a resist is formed by an exposure technique, the ferroelectric film 108 and another electrode 109 are simultaneously etched by a sputter etching. In this case, a part of the polysilicon film 106 may be etched simultaneously. (See Fig. 1(a)).

Then, the remaining polysilicon film is removed by reactive ion etching. (See Fig. 1(b)).

The top electrode 109 of the ferroelectric film and the interconnect layer 110 are formed at the same time and comprise Al. A second interlayer insulating film 112 of phosphorus glass having a thickness of 4000 Å is formed by a chemically vapor phase growing method. (see Fig. 1(c)).

According to the steps shown in Fig. 1, the ferroelectric film is directly formed on the high concentration diffusion layer, and the lower electrode is directly in contact with the high concentration diffusion layer via the polysilicon film, so that the wiring is only needed for the upper electrode, and high integration with a small element area is possible.

If no polysilicon film is used in the structure of Fig. 1, the ferroelectric film thickness is not uniform due to the step difference of the contact hole, and as a result, the ferroelectric capacitor characteristics are degraded reducing the number of read/write cycles to less than 10⁵ times. Further, the breakdown voltage is reduced to 12 V. On the other hand, where a polysilicon film 106 is located between an electrode 107 and a high concentration diffusion layer by a chemical vapor phase growing method, since polysilicon has good adhesivity, the step difference of the contact hole is mitigated, and the film thickness of the ferroelectric film is more uniform improving read/write cycles to 10¹⁰ times, and improving the breakdown voltage to 30 V.

A non-volatile memory is mainly explained above, but the invention can be applied to a memory (DRAM and the like) with the aid of a large specific dielectric constant of the ferroelectric as a matter of course.

The present invention comprises the steps of forming a polysilicon film between either one of the electrodes formed by sandwiching a ferroelectric film and a high concentration diffusion layer by a chemical vapor phase growing method, simultaneously etching said electrode and a part of said polysilicon film with the use of sputter etching, and removing the remaining polysilicon film by reactive ion etching, so that the step difference of a contact hole is mitigated, add a film thickness of the ferroelectric film is uniformly formed, and thereby performing an effect of integrating the ferroelectric film having no increase of element area and excellent electrical characteristics.

## Claims

1. A method for forming a semiconductor device comprising the steps of:
forming a substrate (101) with a source region (103) and a drain region (104) therein;
establishing a gate electrode (105) over said substrate (101) and between said source region (103) and said drain region (104);
establishing an insulating layer (111) over said substrate (101) and around said gate electrode (105);
establishing a contact hole in said insulating layer (111) to said source region (103);
establishing a polysilicon film (106) located directly over and in direct contact with the source region (103) in said contact hole, the polysilicon film (106) also being located over said insulating layer (111);
establishing a lower electrode (107) over said polysilicon film (106);
establishing a ferroelectric film (108) over said lower electrode (107);
etching said lower electrode (107) and said ferroelectric film (108);
etching said polysilicon film (106) and lower electrode (107) using etching which has a low selection ratio so that said polysilicon film (106) remains in said contact hole and etching the remaining polysilicon film (106) using etching which has a high selection ratio with silicon oxide so that said polysilicon film (106) remains over a portion of said insulating layer (111); and
establishing an upper electrode (109) over said ferroelectric film (108).

2. The method of Claim 1 wherein said polysilicon film (106) is established by chemically vapour growing said film and has a thickness at least equal to the thickness of the insulating layer (111).

3. The method of Claim 1 further comprising the steps of establishing a second insulating layer (112) over said insulating layer (111) and defining a wiring electrode (110) in said second insulating layer (112) to said drain region (104).

4. A semiconductor device comprising:
a substrate (101) with a source region (103) and a drain region (104) located therein;
a gate electrode (105) located over said substrate (101) and between said source region (103) and said drain region (104);
an insulating layer (111) located over said substrate (101) and around said gate electrode (105);
a lower electrode (107) located above said source region (103);
a ferroelectric film (108) located over said lower electrode (107); and
an upper electrode (109) located over said ferroelectric film (108);
characterised in that
a polysilicon film (106) is located in a contact hole in said insulating layer (111) and located directly over and in direct contact with said source region (103) and located over a portion of said insulating layer (111); the lower electrode (107) being located over said polysilicon film (106).

5. The device of Claim 4 wherein said lower electrode (107) is comprised of an element from the group comprised of platinum and palladium.

6. The device of Claim 4 wherein said ferroelectric film (108) is comprised of PZT.

7. The device of Claim 4 wherein said upper electrode (109) is comprised of aluminum.

## Patentansprüche

1. Verfahren zum Ausbilden einer Halbleitervorrichtung, mit den Schritten
des Ausbildens eines Substrates (101) mit einem Source-Bereich (103) und einem Drain-Bereich (104);
des Ausbildens einer Gate-Elektrode (105) auf dem Substrat (101) und zwischen dem Source-Bereich (103) und dem Drain-Bereich (104);
des Ausbildens einer Isolierschicht (111) auf dem Substrat (101) und um die Gate-Elektrode (105);
des Ausbildens einer Kontaktöffnung in der Isolierschicht (111) zum Source-Bereich (103);
des Ausbildens einer Polysiliziumschicht (106) direkt über und in direktem Kontakt mit dem Source-Bereich (103) in der Kontaktöffnung, wobei sich die Polysiliziumschicht (106) auch über der Isolierschicht (111) befindet;
des Ausbildens einer unteren Elektrode (107) auf der Polysiliziumschicht (106);
des Ausbildens einer ferroelektrischen Schicht (108) auf der unteren Elektrode (107);
des Ätzens der unteren Elektrode (107) und der ferroelektrischen Schicht (108);
des Ätzens der Polysiliziumschicht (106) und der unteren Elektrode (107) durch Ätzen mit kleinem Selektivverhältnis, so daß die Polysiliziumschicht (106) in der Kontaktöffnung verbleibt, und des Ätzens der verbleibenden Polysiliziumschicht (106) durch Ätzen mit großem Selektivverhältnis zu Siliziumoxid, so daß die Polysiliziumschicht (106) auf einem Teil der Isolierschicht (111) verbleibt; und
des Ausbildens einer oberen Elektrode (109) auf der ferroelektrischen Schicht (108).

2. Verfahren nach Anspruch 1, wobei die Polysiliziumschicht (106) durch chemisches Aufwachsenlassen der Schicht aus der Gasphase ausgebildet wird und eine Dicke hat, die wenigsten gleich der Dicke der Isolierschicht (111) ist.

3. Verfahren nach Anspruch 1, mit den weiteren Schritten des Ausbildens einer zweiten Isolierschicht (112) über der Isolierschicht (111) und des Festlegens einer Anschlußelektrode (110) für den Drain-Bereich (104) in der zweiten Isolierschicht (112).

4. Halbleitervorrichtung, mit
einem Substrat (101) mit einem Source-Bereich (103) und einem Drain-Bereich (104);
einer Gate-Elektrode (105) auf dem Substrat (101) und zwischen dem Source-Bereich (103) und dem Drain-Bereich (104);
einer Isolierschicht (111) auf dem Substrat (101) und um die Gate-Elektrode (105);
einer unteren Elektrode (107) über dem Source-Bereich (103);
einer ferroelektrischen Schicht (108) über der unteren Elektrode (107); und
einer oberen Elektrode (109) auf der ferroelektrischen Schicht (108);
dadurch **gekennzeichnet,** daß
in einer Kontaktöffnung in der Isolierschicht (111) direkt über und in direktem Kontakt mit dem Source-Bereich (103) und über einem Teil der Isolierschicht (111) eine Polysiliziumschicht (106) angeordnet ist; wobei sich die untere Elektrode (107) auf der Polysiliziumschicht (106) befindet.

5. Vorrichtung nach Anspruch 4, wobei die untere Elektrode (107) aus einem Element aus einer Gruppe besteht, die Platin und Palladium umfaßt.

6. Vorrichtung nach Anspruch 4, wobei die ferroelektrische Schicht (108) aus PZT besteht.

7. Vorrichtung nach Anspruch 4, wobei die obere Elektrode (109) aus Aluminium besteht.

## Revendications

1. Procédé de fabrication d'un dispositif à semi-conducteur comprenant les opérations consistant à :
réaliser un substrat (101) avec à l'intérieur une région source (103) et une région collecteur (104) ;
former une électrode de grille (105) sur ledit substrat (101) et entre ladite région source (103) et ladite région collecteur (104) ;
former une couche isolante (111) sur ledit substrat (101) et autour de ladite électrode de grille (105) ;
former dans ladite couche isolante (111) un orifice de contact avec ladite région source (103) ;
former un film de polysilicium (106) disposé directement sur et en contact direct avec la région source (103) dans ledit orifice de contact, le film de polysilicium (106) étant aussi disposé sur ladite couche isolante (111) ;
former une électrode inférieure (107) sur ledit film de polysilicium (106) ;
former un film ferroélectrique (108) sur ladite électrode inférieure (107) ;
graver ladite électrode inférieure (107) et ledit film ferroélectrique (108) ;
graver ledit film de polysilicium (106) et l'électrode inférieure (107) en utilisant une gravure qui a un faible rapport de sélection de manière que ledit film de polysilicium (106) subsiste dans ledit orifice de contact et graver le film de polysilicium restant (106) en utilisant une gravure qui a un rapport de sélection élevé par rapport à l'oxyde de silicium de manière que ledit film de polysilicium (106) subsiste sur une partie de ladite couche isolante (111) ; et
former une électrode supérieure (109) sur ledit film ferroélectrique (108).

2. Procédé selon la revendication 1, dans lequel ledit film de polysilicium (106) est formé en faisant croître chimiquement en phase vapeur ledit film et a une épaisseur au moins égale à l'épaisseur de la couche isolante (111).

3. Procédé selon la revendication 1 comprenant en outre les opérations consistant à former une seconde couche isolante (112) sur ladite couche isolante (111) et à définir une électrode de câblage (110) dans ladite seconde couche isolante (112) jusqu'à ladite région collecteur (104).

4. Dispositif à semi-conducteur comprenant :
un substrat (101) avec une région source (103) et une région collecteur (104) disposées en son sein ;
une électrode de grille (105) disposée sur ledit substrat (101) et entre ladite région source (103) et ladite région collecteur (104) ;
une couche isolante (111) disposée sur ledit substrat (101) et autour de ladite électrode de grille (105) ;
une électrode inférieure (107) disposée sur ladite région source (103) ;
un film ferroélectrique (108) disposé sur ladite électrode inférieure (107) ; et
une électrode supérieure (109) disposée sur ledit film ferroélectrique (108) ;
caractérisé en ce
qu'un film de polysilicium (106) est disposé dans un orifice de contact dans ladite couche isolante (111) et disposé directement sur et en contact direct avec ladite région source (103) et disposé sur une partie de ladite couche isolante (111) ; l'électrode inférieure (107) étant disposée sur ledit film de polysilicium (106).

5. Dispositif selon la revendication 4, dans lequel ladite électrode inférieure (107) est constituée par un élément du groupe comprenant le platine et le palladium.

6. Dispositif selon la revendication 4, dans lequel ledit film ferroélectrique (108) est constitué par du PZT.

7. Dispositif selon la revendication 4, dans lequel ladite électrode supérieure (109) est constituée par de l'aluminium.
